# FASCICULE DE BREVET EUROPEEN

(11) **EP 3 740 974 B1**
(45) Date de publication et mention de la délivrance du brevet: **27.03.2024**
(21) Numéro de dépôt: 19706731.7
(22) Date de dépôt: 17.01.2019
(51) Int. Cl.: H01L 33/00, H01L 33/38, H01L 33/44

(54) **DISPOSITIF OPTOÉLECTRONIQUE COMPORTANT UNE GRILLE ET UNE CATHODE COUPLÉES L'UNE A L'AUTRE**
OPTOELEKTRONISCHE VORRICHTUNG UMFASSEND EIN GITTER UND EINE KATHODE GEKOPPELT MITEINANDER
OPTOELECTRONIC DEVICE COMPRISING A GRID AND A CATHODE COUPLED TO EACH OTHER

(30) Priorité: 19.01.2018 FR 1850444
(43) Date de publication de la demande: 25.11.2020
(73) Titulaire: Commissariat à l'énergie atomique et aux énergies alternatives, 75015 Paris (FR); THALES, 92400 Courbevoie (FR)
(72) Inventeur: BONO, Hubert, 38054 GRENOBLE CEDEX 9 (FR); ROBIN, Ivan-Christophe, 38054 GRENOBLE CEDEX 9 (FR)
(74) Mandataire: Brevalex
(86) Numéro de dépôt international: PCT/FR2019/050096
(87) Numéro de publication internationale: WO 2019/141948

(56) Documents cités:
- US-A1- 2011 062 488
- US-A1- 2012 074 441
- US-A1- 2016 351 758

## Description

### DOMAINE TECHNIQUE ET ART ANTÉRIEUR

L'invention concerne le domaine des dispositifs optoélectroniques à jonction p-n tels que des diodes électroluminescentes (DELs ou LEDs ou micro-LEDs), utilisées notamment pour la réalisation de tout dispositif lumineux à base de LEDs (écrans, projecteurs, murs d'images, etc.), ou des dispositifs photodétecteurs tels que des photodiodes. L'invention s'applique avantageusement à des dispositifs optoélectroniques aptes à émettre et/ou recevoir de la lumière dans la gamme des longueurs d'onde allant du domaine UV à celui de l'infrarouge (comprises entre environ 100 nm et 10 µm).

Une diode électroluminescente émettant une lumière bleue comprend généralement une jonction p-i-n comportant :
- une couche de GaN dopée p à typiquement 10¹⁹ accepteurs/cm³,
- une zone non intentionnellement dopée, ou intrinsèque, de GaN comprenant typiquement 10¹⁷ donneurs/cm³ et dans laquelle sont formés des puits quantiques d'InGaN, et
- une couche de GaN dopée n avec typiquement 10¹⁹ donneurs/cm³.

La zone non intentionnellement dopée et comprenant les puits quantiques dans lesquels se produit l'émission lumineuse est appelée zone active.

Une couche de blocage d'électrons en AlGaN avec une concentration en aluminium comprise entre 8 % et 15 % et dopée p peut être rajoutée entre la zone active et la couche de GaN dopée p, comme décrit dans le document « The influence of acceptor anneal température on the performance of InGaN/GaN quantum well light-emitting diodes », J. D. Thomson et al., Journal of Applied Physics 99, 024507 (2006). Cette couche de blocage d'électrons permet de limiter le déplacement des électrons de la zone active vers la couche de GaN dopée p.

Le principal problème limitant l'efficacité de ce type de diode électroluminescente est l'énergie d'activation élevée des accepteurs dans la couche de GaN dopée p, qui est typiquement de l'ordre de 200 meV.

Une diode électroluminescente émettant dans le domaine de l'ultraviolet (LED UV) peut être réalisée en utilisant de l'AIGaN pour former la jonction p-i-n, avec des puits quantiques en GaN. Plus la concentration en aluminium dans l'AIGaN augmente, plus l'énergie d'activation des accepteurs dans l'AIGaN dopé p augmente. A titre d'exemple, cette énergie d'activation est de l'ordre de 600 meV dans l'AIN. La quantité d'accepteurs activés dans l'AIGaN est alors extrêmement faible, limitant d'autant l'efficacité d'une telle LED UV.

Pour réduire l'énergie d'activation des accepteurs dans une telle LED UV, du GaN dopé p peut être utilisé à la place de l'AIGaN dopé p. Cela a par contre comme inconvénient de limiter l'efficacité radiative dans la zone active de la LED UV qui est en AlGaN. De plus, une partie de la lumière UV émise par la zone active est absorbée par le GaN dopé p.

Dans les exemples décrits ci-dessus, les limitations observées sont dues à l'énergie d'activation élevée des accepteurs dans la jonction p-n. Il est également possible de rencontrer des problèmes analogues liés à une énergie d'activation élevée des donneurs lorsqu'ils sont profonds. Par exemple, ces problèmes se retrouvent dans le cas de LEDs dont les jonctions p-n sont réalisées en diamant car dans ce cas, les donneurs ont une forte énergie d'ionisation (de l'ordre de 460 meV).

De plus, les problèmes similaires se retrouvent dans des photodiodes, par exemple celles destinées à réaliser une détection de lumière UV et réalisées à partir d'AIGaN ou de diamant.

Afin de résoudre ces problèmes et permettre d'améliorer l'efficacité quantique interne d'une LED ou d'une photodiode, notamment lorsque des matériaux semi-conducteurs ayant des énergies d'activation d'accepteurs ou de donneurs élevées sont utilisés, le document EP 2 960 951 A1 décrit un dispositif optoélectronique (par exemple une LED ou une photodiode) comportant une jonction p-n réalisée sous la forme d'une structure mesa et couplée à un élément apte à ioniser des dopants de la jonction p-n via la génération d'un champ électrique, cet élément étant formé contre une partie des flancs latéraux de la jonction p-n.

Bien qu'un tel élément de ionisation de dopants soit efficace, cette structure nécessite d'avoir accès à trois électrodes: une pour l'anode, une pour la cathode, et une pour l'élément de ionisation. De plus, dans un tel dispositif, il est nécessaire de graver la zone active entre les structures mesa, ce qui engendre une perte d'efficacité surfacique importante à l'échelle du dispositif.

### EXPOSÉ DE L'INVENTION

Un but de la présente invention est de proposer un dispositif optoélectronique dans lequel l'efficacité ne soit pas limitée par une énergie d'activation des accepteurs importante dans une couche dopée p du dispositif, qui ne nécessite pas un accès à trois électrodes distinctes et dont la structure n'implique pas de graver une zone active du dispositif.

Pour cela, la présente invention propose un dispositif optoélectronique comportant au moins :
- une première couche de semi-conducteur dopé p et une deuxième couche de semi-conducteur dopé n superposées et formant ensemble une jonction p-n ;
- une première électrode reliée électriquement à la première couche de semi-conducteur et formant une anode du dispositif optoélectronique ;
- une grille comprenant au moins un diélectrique de grille et une couche de matériau électriquement conducteur de la grille, disposée contre au moins un flanc latéral d'au moins une partie de la première couche de semi-conducteur et ne recouvrant pas des flancs latéraux de la deuxième couche ;
- une deuxième électrode disposée contre au moins un des flancs latéraux d'au moins une partie de la deuxième couche de semi-conducteur, reliée électriquement à ladite partie de la deuxième couche de semi-conducteur et isolée électriquement de la première couche de semi-conducteur;
et dans lequel au moins une portion de la deuxième électrode est disposée contre le matériau électriquement conducteur de la grille telle que la deuxième électrode soit reliée électriquement au matériau électriquement conducteur de la grille et forme à la fois une électrode de grille et une cathode du dispositif optoélectronique.

Dans un tel dispositif optoélectronique, du fait que la deuxième électrode forme à la fois l'électrode de grille et la cathode du dispositif optoélectronique, un accès à seulement deux électrodes est suffisant pour commander le dispositif optoélectronique.

En polarisant la cathode et la grille au même potentiel, le dispositif optoélectronique fonctionne donc en accumulation.

Grâce à l'application d'un potentiel électrique sur la grille différent de celui appliqué sur l'anode, cette différence de potentiels obtenue entre la zone p et la grille permet de créer un canal d'accumulation dans le ou les flancs latéraux du semi-conducteur dopé p qui est ou sont recouverts par la grille. Cela permet d'augmenter l'efficacité du dispositif optoélectronique (efficacité d'émission dans le cas d'une LED) même si celui-ci est fabriqué en utilisant des matériaux ayant des énergies d'activation des accepteurs importantes.

En particulier, cette structure permet d'augmenter l'efficacité d'émission de LEDs fabriquées à partir de GaN et comprenant un zone active incluant des puits d'InGaN, ou de LEDs fabriquées à partir d'AIGaN et comprenant une zone active incluant des puits de GaN.

Enfin, l'accès au flanc latéral ou aux flancs latéraux du semi-conducteur dopé p contre lequel ou lesquels la grille est disposée n'impose pas de graver la jonction p-n sur toute son épaisseur, et préserve notamment une éventuelle zone active du dispositif qui serait disposée au sein de la jonction p-n.

La grille ne recouvre que les flancs latéraux du semi-conducteur dopé p et non ceux du semi-conducteur dopé n, ce qui permet de faire fonctionner le dispositif en régime d'accumulation.

La grille peut être configurée pour créer un canal d'accumulation au niveau des flancs latéraux de semi-conducteur dopé p recouverts par la grille.

La grille comporte un diélectrique de grille, qui peut avoir une permittivité supérieure à environ 3,2 et une épaisseur d'oxyde équivalente (EOT, représente l'épaisseur équivalente de SiO₂ permettant d'obtenir le même isolation) comprise entre environ 0,5 nm et 100 nm. Un tel diélectrique de grille permet d'avoir, dans le diélectrique de grille, un courant de fuite faible et un champ électrique important (le courant de fuite variant de manière inverse au champ électrique). Le diélectrique de grille correspond dans ce cas à un diélectrique dit « High-k », correspondant par exemple à du HfOz, de l'Al₂O₃, du TazOs, ou du ZrOz, dont l'épaisseur est par exemple comprise entre environ 2 nm à 50 nm.

Le dispositif peut comporter au moins un trou et/ou une tranchée traversant la première couche de semi-conducteur, et la grille peut être disposée contre au moins une partie des flancs latéraux du trou et/ou de la tranchée formée par la première couche de semi-conducteur.

En particulier, plusieurs tranchées peuvent traverser la première couche de semi-conducteur, la grille pouvant être dans ce cas disposée, dans chacune des tranchées, contre les flancs latéraux formés par la première couche de semi-conducteur. Avec de telles tranchées, la surface de grille contre le semi-conducteur dopé p est maximisée.

En outre, au moins une partie de la deuxième électrode peut traverser au moins la deuxième couche de semi-conducteur depuis une paroi de fond du trou et/ou de la tranchée.

En variante, il est possible qu'au moins une partie de la deuxième électrode puisse traverser les première et deuxième couches de semi-conducteur, avec dans ce cas une isolation électrique présente entre la deuxième électrode et la partie de la première couche de semi-conducteur traversée par la deuxième électrode.

Une partie de la grille est disposée sur la première couche de semi-conducteur et être en contact avec la deuxième électrode.

Le dispositif peut comporter en outre au moins une couche métallique recouvrant la première couche de semi-conducteur et qui est en contact avec la première électrode. Dans ce cas, lorsque le dispositif comporte au moins un trou et/ou une tranchée traversant la première couche de semi-conducteur, le ou les trous et/ou tranchées peuvent traverser également cette couche métallique.

La première couche de semi-conducteur et/ou la deuxième couche de semi-conducteur peut comporter avantageusement de l'AIGaN.

Le dispositif optoélectronique peut correspondre à une diode électroluminescente ou à une photodiode.

L'invention concerne également un procédé de réalisation d'un dispositif optoélectronique comportant au moins les étapes de :
- réalisation d'une première couche de semi-conducteur dopé p et d'une deuxième couche de semi-conducteur dopé n superposées et formant ensemble une jonction p-n ;
- réalisation d'une grille comprenant au moins un diélectrique de grille et une couche de matériau électriquement conducteur de la grille, disposée contre au moins un flanc latéral d'au moins une partie de la première couche de semi-conducteur et ne recouvrant pas des flancs latéraux de la deuxième couche;
- réalisation d'une première électrode reliée électriquement à la première couche de semi-conducteur et formant une anode du dispositif optoélectronique ;
- réalisation d'une deuxième électrode disposée contre au moins un des flancs latéraux d'au moins une partie de la deuxième couche de semi-conducteur, reliée électriquement à ladite partie de la deuxième couche de semi-conducteur et isolée électriquement de la première couche de semi-conducteur, et telle qu'au moins une portion de la deuxième électrode soit disposée contre le matériau électriquement conducteur de la grille afin que la deuxième électrode soit reliée électriquement au matériau électriquement conducteur de la grille et forme à la fois une électrode de grille et une cathode du dispositif optoélectronique.

Le procédé peut comporter en outre, entre la réalisation des première et deuxième couches de semi-conducteur et la réalisation de la grille, la réalisation d'au moins un trou et/ou une tranchée à travers la première couche de semi-conducteur, et la grille peut être réalisée ensuite telle qu'elle soit disposée contre au moins une partie des flancs latéraux du trou et/ou de la tranchée formée par la première couche de semi-conducteur.

De plus, la réalisation de la deuxième électrode peut comporter la réalisation d'au moins une ouverture à travers au moins la deuxième couche de semi-conducteur depuis une paroi de fond du trou et/ou de la tranchée, puis le remplissage de l'ouverture par au moins un matériau électriquement conducteur.

Le procédé peut être tel que :
- la réalisation de la jonction p-n comporte en outre la réalisation d'une zone active émissive disposée entre les première et deuxième couches de semi-conducteur,
- lorsqu'un trou et/ou une tranchée est réalisé à travers la première couche de semi-conducteur, une gravure formant le trou et/ou la tranchée est stoppée sur la zone active émissive telle qu'une paroi de fond du trou et/ou de la tranchée soit formée par la zone active émissive,
- la grille est réalisée telle qu'elle recouvre la paroi de fond du trou et/ou de la tranchée.

La grille peut être réalisée par la mise en oeuvre d'un dépôt d'au moins un matériau diélectrique de grille contre ledit au moins un flanc latéral d'au moins une partie de la première couche de semi-conducteur et sur la première couche de semi-conducteur, et d'un dépôt du matériau électriquement conducteur de la grille sur le matériau diélectrique de grille, et dans lequel la deuxième électrode peut être réalisée telle que la portion de la deuxième électrode qui disposée contre le matériau électriquement conducteur de la grille soit disposée sur la première couche de semi-conducteur.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif optoélectronique, objet de la présente invention, selon un mode de réalisation particulier ;
- les figures 2A à 2J représentent des étapes d'un procédé de réalisation d'un dispositif optoélectronique, objet de la présente invention, selon un mode de réalisation particulier;
- la figure 3 représente une vue de dessus d'un dispositif optoélectronique, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

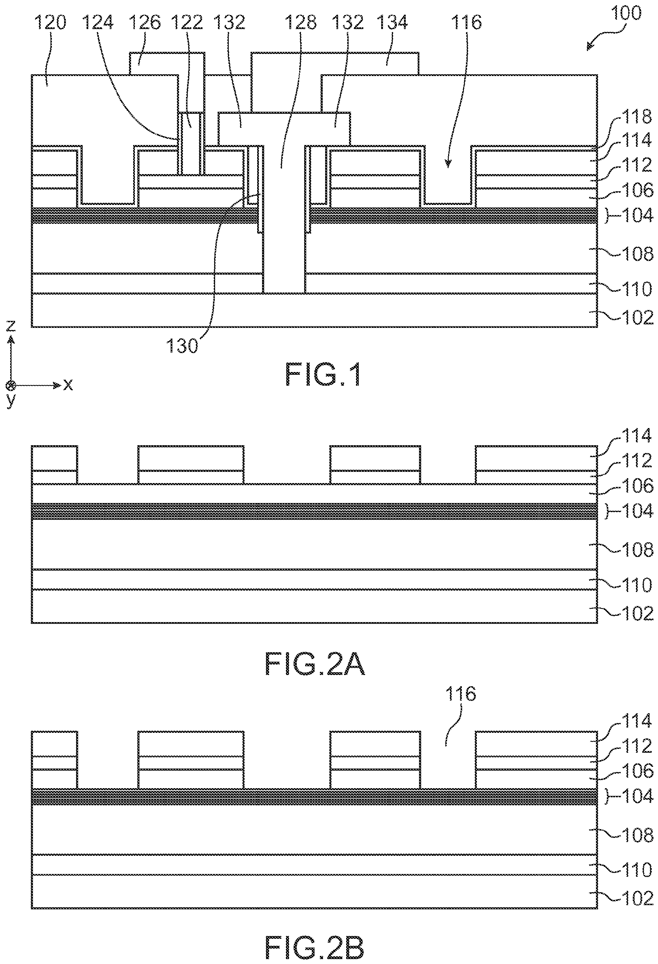

On se réfère tout d'abord à la figure 1 qui représente un dispositif optoélectronique 100 selon un mode de réalisation particulier. Dans ce mode de réalisation, le dispositif optoélectronique 100 correspond à une diode électroluminescente, ou LED.

La LED 100 comporte un substrat 102 destiné à servir de support pour la croissance des autres couches de la LED 100. Ce substrat 102 comporte par exemple du saphir, et son épaisseur (dimension parallèle à l'axe Z représenté sur la figure 1) est par exemple égale à environ 500 µm.

La LED 100 comporte une zone active 104 comprenant une ou plusieurs couches émissives formant chacune un puits quantique, comportant par exemple de l'AIGaN, et étant chacune disposée entre deux couches barrières, comportant par exemple du GaN ou de l'AIGaN (avec une concentration en aluminium inférieure à celle de l'AIGaN de la ou des couches émissives). L'AIGaN des couches émissives comporte par exemple 50 % d'aluminium, ce qui permet d'obtenir une émission de lumière UV à une longueur d'onde égale à environ 260 nm. Toutes les couches de la zone active 104, c'est-à-dire la ou les couches émissives et les couches barrières, comportent des matériaux semi-conducteurs intrinsèques, c'est-à-dire non intentionnellement dopés (de concentration en donneurs résiduels n_{nid} par exemple égale à environ 10¹⁷ donneurs/cm³, ou comprise entre environ 10¹⁵ et 10¹⁸ donneurs/cm³). L'épaisseur de la ou de chacune des couches émissives est par exemple égale à environ 1 nm et plus généralement comprise entre environ 0,5 nm et 10 nm, et l'épaisseur de chacune des couches barrières est par exemple égale à environ 5 nm ou comprise entre environ 1 nm et 25 nm. La zone de charge d'espace de la LED 100 est principalement située dans cette zone active 104.

En variante, la zone active 104 peut être réalisée à base de GaN avec une ou plusieurs couches émissives comportant de l'InGaN.

La zone active 104 est disposée entre une première couche de semi-conducteur 106 qui est dopée p, et une deuxième couche de semi-conducteur 108 qui est dopée n, les deux couches de semi-conducteur 106 et 108 formant la jonction p-n de la LED 100 (ou plus précisément la jonction p-i-n en considérant la zone active 104 comportant du semi-conducteur intrinsèque interposé entre les couches dopées 106 et 108). Ces couches 106, 108 et la zone active 104 sont agencées les unes des autres telles que la deuxième couche 108 soit disposée entre la zone active 104 et le substrat 102.

Les couches 106 et 108 comportent par exemple de l'AIGaN. En outre, l'AIGaN des couches 106, 108 comporte par exemple 70 % d'aluminium. La première couche 106 est dopée p avec une concentration d'accepteurs (trous) par exemple comprise entre environ 10¹⁷ et 5.10¹⁹ accepteurs/cm³, et ici égale à 5.10¹⁷ accepteurs/cm³. La deuxième couche 108 est dopée n avec une concentration de donneurs (électrons) par exemple comprise entre environ 10¹⁷ et 5.10¹⁹ donneurs/cm³, et ici égale à 5.10¹⁸ donneurs/cm³. Les deux couches de semi-conducteur 108 et 106 ont par exemple chacune une épaisseur comprise entre environ 20 nm et 10 µm. Dans l'exemple décrit ici, la première couche de semi-conducteur 106 a une épaisseur égale à environ 200 nm, et la deuxième couche de semi-conducteur 108 a une épaisseur égale à environ 1 µm. La deuxième couche de semi-conducteur 108 est disposée sur une couche tampon 110, ou couche buffer, interposée entre la deuxième couche 108 et le substrat 102, et comportant par exemple de l'AIGaN dopé n avec une concentration par exemple égale à environ 10¹⁹ donneurs/cm³, et d'épaisseur égale à environ 2 µm. La couche tampon 110 comporte avantageusement le même semi-conducteur et est dopée du même type que la deuxième couche 108.

Des proportions d'aluminium autres que celles décrites ci-dessus, ou bien encore des matériaux semi-conducteurs autres que l'AIGaN, comme par exemple le GaN et/ou l'InGaN, peuvent être utilisés au sein de la LED 100, notamment selon la gamme de longueurs d'ondes destinées à être émises par la LED 100.

La LED 100 comporte également une couche de matériau électriquement conducteur 112, ici métallique, disposée sur la première couche de semi-conducteur 106 et reliée électriquement à celle-ci, formant ainsi une partie de l'anode, de la LED 100. La couche 112 comporte par exemple de l'Ag et/ou de l'AI. La couche 112 a une épaisseur par exemple comprise entre environ 20 nm et 2 µm.

La couche 112 est recouverte d'un masque dur 114 comprenant un matériau diélectrique, par exemple du SiOz et servant, lors de la réalisation de la LED 100, à la réalisation de tranchées 116 formées à travers les couches 106 et 112. L'épaisseur du masque dur 114 est par exemple comprise entre environ 100 nm et 2 µm.

Les tranchées 116 réalisées à travers les couches 112 et 106 forment des emplacements dans lesquels est formée une grille de la LED 100. De manière générale, un ou plusieurs trous et/ou tranchées 116 sont réalisés à travers au moins la première couche 106 afin de former, pour la grille, des zones de contact avec le semi-conducteur dopé p.

Une couche de matériau diélectrique de grille et une couche de matériau électriquement conducteur de grille, désignées ensemble par la référence 118 et représentées sur la figure 1 comme formant une unique couche, recouvrent le masque dur 114 ainsi que les parois latérales des tranchées 116, qui sont formées par le masque dur 114 et la première couche 106, et les parois de fond des tranchées 116 formées par la zone active 104. Ces couches 118 forment la grille de la LED 100. La couche de matériau diélectrique de grille peut comporter au moins un matériau diélectrique de préférence de type « high-k », c'est-à-dire dont la constante diélectrique soit supérieure à celle du SiO₂, c'est-à-dire supérieure à environ 3,2. Ainsi, ce matériau correspond par exemple à de l'Al₂O₃, du HfOz, du ZrO₂, du TazOs, ou correspond à un empilement de plusieurs de ces matériaux diélectriques. L'utilisation d'un matériau diélectrique « high-k » permet d'avoir un diélectrique de grille d'épaisseur plus importante que lorsqu'un matériau diélectrique qui n'est pas de type « high-k » est utilisé.

Cette couche de matériau diélectrique de grille est mince et son épaisseur est par exemple comprise entre environ 2 nm et 50 nm. Plus particulièrement, le ou les matériaux diélectriques de grille et l'épaisseur de ce ou ces matériaux sont choisis tels que l'épaisseur d'oxyde équivalente (ou EOT pour « Equivalent Oxide Thickness ») de ce ou ces couches de matériaux soit comprise entre environ 0,5 nm et 100 nm.

La couche de matériau électriquement conducteur de la grille 118 comporte ici une première couche formant une barrière de diffusion, comprenant par exemple du TiN, du TaN, du WN, et une deuxième couche métallique comprenant par exemple du tungstène, de l'aluminium, etc. L'épaisseur de la première couche formant la barrière de diffusion de la grille 118 est par exemple comprise entre environ 1 nm et 20 nm, et celle de la deuxième couche métallique est par exemple comprise entre environ 50 nm et 1 µm. Ce ou ces matériaux conducteurs de grille sont choisis tels qu'ils aient des caractéristiques chimiques compatibles avec les autres matériaux de la LED, en particulier ses propriétés de barrière de diffusion. Les matériaux utilisés sont ici choisis tels que les diagrammes de bandes du semi-conducteur utilisé dans la LED 100, du diélectrique de grille et du matériau conducteur de grille minimisent l'énergie d'extraction des charges électriques du matériau conducteur de grille, donc la tension de grille. Par exemple, lorsque la LED 100 est réalisée à partir d'AIGaN, un empilement de type Al₂O₃ / TiN / W peut être utilisé pour former la grille 118.

En raison des tranchées 116 réalisées à travers les couches 106, 112 et 114, la grille 118 est disposée contre les parois latérales de plusieurs portions de la première couche de semi-conducteur 106, ce qui permet d'avoir globalement au sein de la LED 100 une surface de contact importante entre la grille 118 et la première couche de semi-conducteur 106. En outre, comme cela est visible sur la figure 1, la grille 118 ne recouvre que les flancs latéraux du semi-conducteur dopé p de la couche 106 et non ceux du semi-conducteur dopé n de la couche 108.

La grille 118 est recouverte d'un autre matériau diélectrique 120, par exemple du SiOz ou du SiN, dont l'épaisseur est par exemple comprise entre environ 10 nm et 10 µm.

La couche 112 est accessible électriquement depuis l'extérieur de la LED 100 grâce à une première électrode 122 réalisée à travers le matériau diélectrique 120, la grille 118 et le masque dur 114, et qui est en contact électriquement avec la couche 112. La première électrode 122 forme l'anode de la LED 100. Une partie des parois latérales de cette première électrode 122, notamment au niveau du masque dur 114 et de la grille 118, est recouverte d'une couche diélectrique 124, assurant notamment une isolation électrique entre la grille 118 et la première électrode 122. La première électrode 122 comporte une partie 126 s'étendant sur le matériau diélectrique 120 et formant un plot de contact à partir duquel un potentiel électrique peut être appliqué depuis l'extérieur de la LED 100.

Une deuxième électrode 128 traverse le matériau diélectrique 120. Cette deuxième électrode 128 est formée dans une des tranchées 116 et traverse la grille 118, la zone active 104, la couche 108 et la couche tampon 110. Une couche diélectrique 130 recouvre une partie des parois latérales de cette deuxième électrode 128 afin d'isoler électriquement cette deuxième électrode 128 vis-à-vis de la zone active 104. Une partie des parois latérales de la deuxième électrode 128 est en contact électriquement avec les couches 108 et 110, cette deuxième électrode 128 forme la cathode de la LED 100.

Des portions 132 de la deuxième électrode 128 sont disposées sur la grille 118 et sont reliées électriquement au matériau conducteur de la grille 118. Ainsi, cette deuxième électrode 128 permet l'application d'un même potentiel électrique sur la grille 118 et sur les couches 108 et 110 dopées n. La deuxième électrode 128 comporte une partie 134 s'étendant sur le matériau diélectrique 120 et formant un plot de contact à partir duquel un potentiel électrique peut être appliqué depuis l'extérieur de la LED 100.

Les électrodes 122, 128 comportent par exemple chacune un empilement de plusieurs matériaux conducteurs et sont par exemple chacune formé d'un multicouche de type Ti/TiN/Cu, avec des épaisseurs de ces matériaux par exemple comprises entre environ 10 nm et 1 µm. Les couches diélectriques 124 et 130 comportent par exemple du SiN, du TiOz, du SiO₂, de l'Al₂O₃,, du ZrOz, ou du HfOz, et forment, contre les parois latérales des électrodes 122, 128, des couches d'épaisseur par exemple comprise entre environ 50 nm et 5 µm.

Ainsi, dans la LED 100, grâce à la faible épaisseur et la constante diélectrique importante du matériau diélectrique de la grille 118, le courant de fuite à travers ce diélectrique de grille est très faible et le champ électrique obtenu dans ce diélectrique de grille est important. La constante diélectrique importante du diélectrique de grille permet en outre, compte tenu de la faible épaisseur de ce diélectrique, d'éviter l'apparition d'une région de conduction par effet tunnel entre le matériau conducteur de grille et le matériau semi-conducteur de la couche 106 qui conduirait à un chute du champ électrique dans le diélectrique de grille.

Dans la LED 100, il est avantageux que la grille soit réalisée avec une densité qui soit plus grande possible afin d'augmenter la surface de semi-conducteur de la couche 106 qui est en contact avec la grille 118. Pour cela, les tranchées 116 peuvent être réalisées avec une densité importante au sein de la LED 100.

La grille 118 disposée autour de la jonction de la LED 100 permet de créer un canal d'accumulation au niveau des flancs latéraux du semi-conducteur dopé p de la couche 106, et d'augmenter ainsi l'efficacité de recombinaison en injectant plus de trous dans la zone active 104. Du fait que la grille 118 est reliée électriquement à la cathode de la LED 100, un fonctionnement en régime d'accumulation de la LED 100 est donc obtenu.

L'effet de la grille 118 autour du semi-conducteur dopé p est bénéfique quelle que soit la structure de la zone active, et notamment quel que soit le nombre de puits quantiques.

Une couche de blocage d'électrons, par exemple en AlGaN avec une concentration en aluminium entre 8 % et 100 % et dopée p peut en outre être disposée entre la zone active 104 et la couche de semi-conducteur dopée p 106. Dans ce cas, il est avantageux de former la grille 118 autour de cette couche de blocage d'électrons.

Selon une variante, la LED 100 peut ne pas comporter la zone active 104, et la première couche de semi-conducteur dopée p 106 est alors disposée directement sur la deuxième couche de semi-conducteur dopée n 108. La zone de charge d'espace se trouve alors uniquement dans la couche 106.

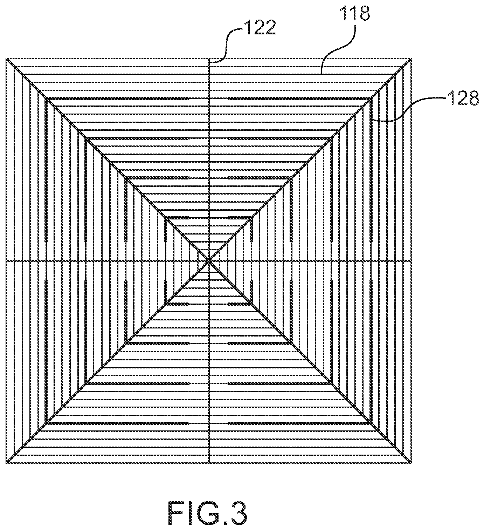

La figure 3 représente une vue de dessus de la LED 100. Sur cette vue de dessus, la grille 118, la première électrode 122 et la deuxième électrode 128 sont réalisées selon une disposition assurant la continuité des électrodes 122, 128 et la connexion entre la grille 118 et la deuxième électrode 128.

Un procédé de réalisation de la LED 100 est décrit ci-dessous en lien avec les figures 2A à 2J.

L'empilement de couches 110, 108, 104, 106 et 112 est tout d'abord réalisé sur le substrat 102. Le masque dur 114 est ensuite réalisé sur la couche 112, par exemple par photolithographie et gravure. Le motif de ce masque dur 114 correspond à celui des tranchées 116 qui destinées à être réalisées ensuite.

La couche 112 est ensuite gravée selon le motif défini par le masque dur 114 (figure 2A).

La couche 106 est ensuite également gravée selon le motif du masque dur 114, avec arrêt sur la zone active 104 (figure 2B). Cette gravure est par exemple de type RIE (gravure ionique réactive) ou plasma ICP, mise en oeuvre en utilisant un agent de gravure de type Cl₂ ou Br. Cette gravure achève la réalisation des tranchées 116 à travers les couches 106, 112 et 114.

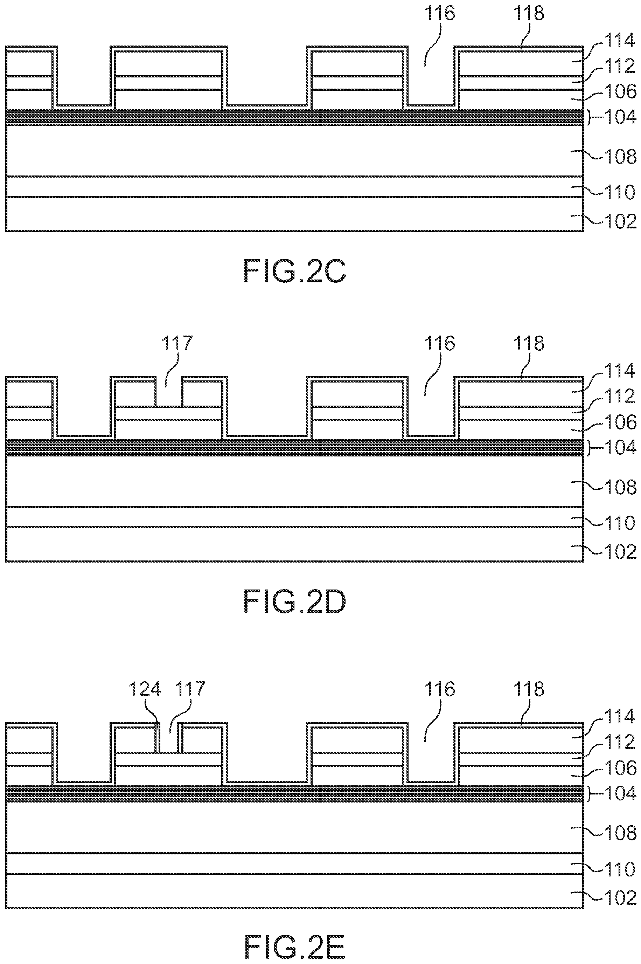

Comme représenté sur la figure 2C, les couches de matériau diélectrique de grille et de matériau conducteur de grille 118 sont ensuite déposées. Le diélectrique de grille réalisé comporte par exemple de l'Al₂O₃, du HFO₂, du TazOs ou du ZrO₂, par exemple déposé par ALD (dépôt en couche atomique). Le ou les matériaux conducteurs de grille sont par exemple du TiN, du TaN ou du WN, par exemple déposé par CVD (dépôt chimique en phase vapeur).

Une ouverture 117 est formée par lithographie et gravure à travers le masque dur 114, formant un accès à la couche électriquement conductrice 112 (figure 2D). Cette ouverture 117 forme l'emplacement de la première électrode 122 destiné à former l'anode de la LED 100.

La couche diélectrique 124 est ensuite formée, par exemple par dépôt et gravure, contre les parois latérales de l'ouverture 117 afin d'assurer par la suite l'isolation électrique entre la première électrode 122 et le grille 118 (figure 2E).

Le matériau diélectrique 120 est ensuite déposé sur l'ensemble de la structure réalisée, recouvrant ainsi la grille 118. Ce matériau diélectrique 120 est disposé notamment dans les tranchées 116 et sur les portions des couches 106, 112, 114 entre lesquelles se trouvent les tranchées 116.

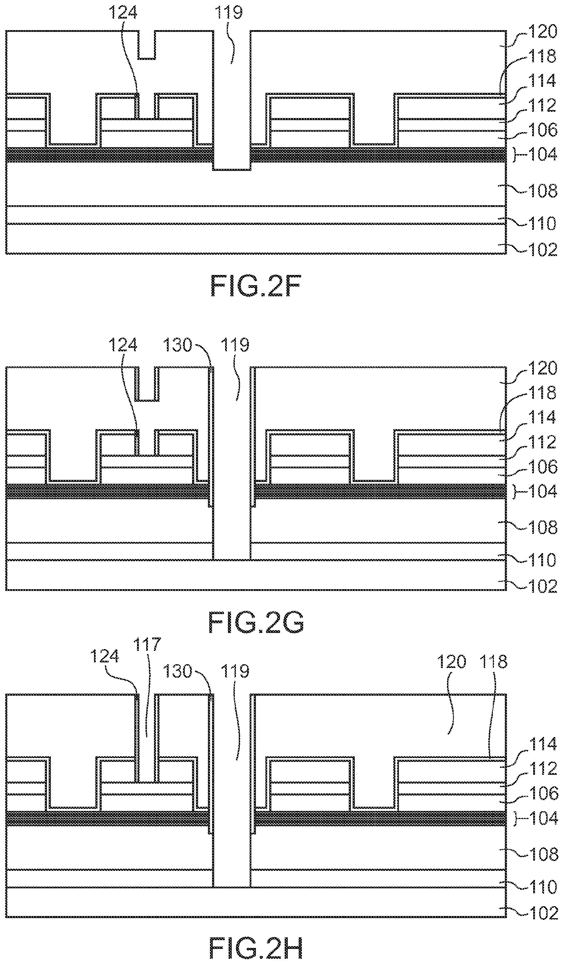

Le matériau diélectrique 120 est ensuite structuré par lithographie et gravure afin de former un masque dur destiné à former un emplacement de la deuxième électrode 128 au sein de la jonction p-n. Pour réaliser cet emplacement, une première gravure de la zone active 104 est mise en oeuvre selon le motif de ce masque dur, formant une ouverture 119 correspondant à cet emplacement (figure 2F). Cette gravure correspond par exemple à une gravure RIE ou plasma ICP mise en oeuvre en utilisant un agent de gravure de type Cl₂ ou Br. Cette gravure forme une partie de l'emplacement. Cette ouverture 119 peut se prolonger à travers une partie de l'épaisseur de la couche 108.

La couche diélectrique 130 est ensuite déposée sur l'ensemble de la structure, et notamment le long des parois de l'ouverture 119 formée à travers la grille 118 et la zone active 104 et éventuellement une partie de la couche 108. Les parties de la couche diélectrique 130 ne recouvrant pas des flancs latéraux formés par le matériau diélectrique 120, c'est-à-dire les parties de cette couche diélectrique disposées sur la face supérieure du matériau diélectrique 120 et sur la paroi de fond de l'ouverture 119, sont supprimées.

L'ouverture 119 est ensuite prolongée à travers les couches 108 et 110 via la mise en oeuvre d'une gravure à travers ces couches, avec un arrêt sur le substrat 102 (figure 2G).

La portion de matériau diélectrique 120 remplissant l'emplacement 117 de la première électrode 122 est ensuite supprimée par gravure (figure 2H). Après l'ouverture totale de l'emplacement 117, du matériau diélectrique est de nouveau déposé afin que la couche diélectrique 124 recouvre l'ensemble des parois latérales de l'emplacement 117, depuis la surface supérieure formée par le matériau diélectrique 120 jusqu'à la couche 112.

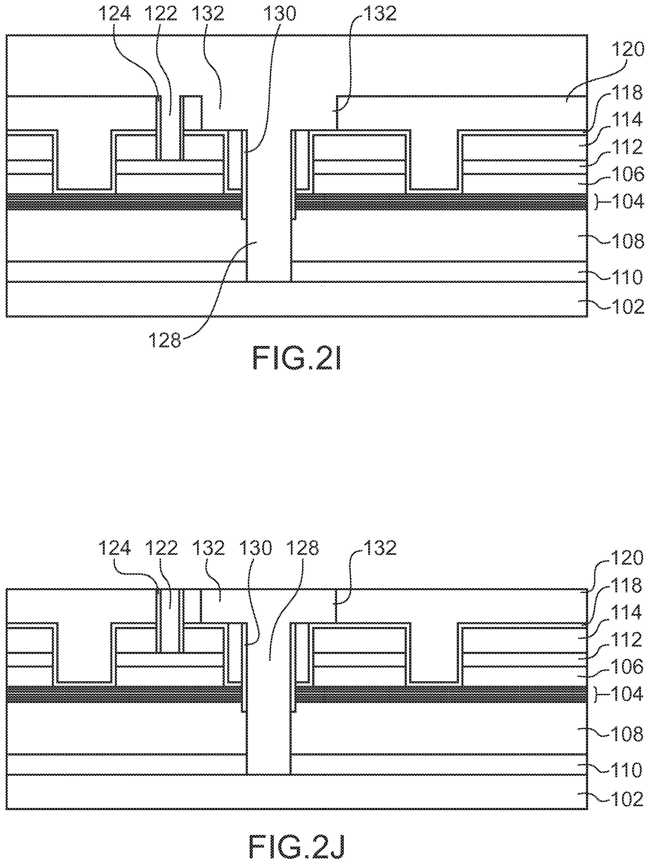

Le matériau diélectrique 120 est ensuite de nouveau gravé afin de former des emplacements pour les portions 132 de la deuxième électrode 128 qui sont destinés à être en contact avec la grille 118. Un ou plusieurs matériaux conducteurs sont ensuite formés notamment dans les ouvertures 117 et 119 pour former les électrodes 122 et 128. Les électrodes 122 et 128 peuvent être réalisées en déposant tout d'abord un empilement de couches métalliques, par exemple une superposition de trois couches de type Ti/TiN/Cu, puis en mettant en oeuvre un dépôt ECD (dépôt électrochimique) de cuivre afin de remplir les ouvertures 117 et 119. Les matériaux conducteurs des électrodes 122 et 128 sont également déposés sur le matériau diélectrique 120 ainsi que dans les emplacements gravés précédemment pour former les portions 320 (figure 2I).

Une planarisation mécano-chimique (CMP) est ensuite mise en oeuvre afin de supprimer les portions de matériaux conducteurs présentes sur le matériau diélectrique 120 (figure 2J).

La LED 100 est ensuite achevée par un dépôt de matériau diélectrique, complétant l'épaisseur de matériau diélectrique 120 déjà présente. Des étapes de lithographie et gravure sont mises en oeuvre pour former à travers ce matériau diélectrique des ouvertures en regard des électrodes 122 et 128. Un ou plusieurs matériaux électriquement conducteurs sont ensuite déposés dans ces ouvertures et sur le matériau diélectrique. La réalisation des électrodes 122 et 128 est achevée en mettant en oeuvre des étapes de lithographie et gravure pour former les parties 126 et 134 formant les plots de contact des électrodes 122 et 128. Le dispositif 100 ainsi obtenu correspond à celui représenté sur la figure 1.

Plusieurs LEDs similaires à la LED 100 peuvent être réalisées les unes à côté des autres sur le substrat 102. De plus, la deuxième couche de semi-conducteur dopée n 108 peut être commune à toutes ces LEDs. Dans ce cas, l'adressage individuel des LEDs peut être réalisé par l'intermédiaire de l'anode propre à chacune des LEDs.

En variante, il est possible de remplacer les grilles par tous dispositifs permettant de créer une zone de charges d'espace à la surface du semi-conducteur de type p, comme par exemple des contacts Schottky ou tous empilements pouvant s'apparenter à une jonction semi-conducteur polarisée en inverse.

Une ou plusieurs LEDs 100 selon l'un des différents modes de réalisation précédemment décrits peuvent être intégrées au sein d'un dispositif émissif lumineux.

En variante des différents exemples de réalisation précédemment décrits, la référence 100 peut correspondre non pas à une LED mais à une photodiode comportant une jonction p-n ou p-i-n. Comme pour la LED précédemment décrite, la ou les grilles servent dans ce cas à créer un canal d'accumulation dans les flancs latéraux du semi-conducteur dopé p qui sont recouverts par la grille.

## Revendications

1. Dispositif optoélectronique (100) comportant au moins :
- une première couche (106) de semi-conducteur dopé p et une deuxième couche (108) de semi-conducteur dopé n superposées et formant ensemble une jonction p-n ;
- une première électrode (122) reliée électriquement à la première couche (106) de semi-conducteur et formant une anode du dispositif optoélectronique (100) ;
- une grille (118), comprenant au moins un diélectrique de grille et une couche de matériau électriquement conducteur de la grille, disposée contre au moins un flanc latéral d'au moins une partie de la première couche (106) de semi-conducteur et ne recouvrant pas des flancs latéraux de la deuxième couche (108) ;
- une deuxième électrode (128) disposée contre au moins un des flancs latéraux d'au moins une partie de la deuxième couche (108) de semi-conducteur, reliée électriquement à ladite partie de la deuxième couche (108) de semi-conducteur et isolée électriquement de la première couche (106) de semi-conducteur ;
et dans lequel au moins une portion (132) de la deuxième électrode (128) est disposée contre le matériau électriquement conducteur de la grille (118) telle que la deuxième électrode (128) soit reliée électriquement au matériau électriquement conducteur de la grille (118) et forme à la fois une électrode de grille et une cathode du dispositif optoélectronique (100).

2. Dispositif optoélectronique (100) selon la revendication 1, dans lequel le diélectrique de grille a une permittivité supérieure à environ 3,2 et une épaisseur d'oxyde équivalente comprise entre environ 0,5 nm et 100 nm.

3. Dispositif optoélectronique (100) selon l'une des revendications précédentes, comportant au moins un trou et/ou une tranchée (116) traversant la première couche (106) de semi-conducteur, et dans lequel la grille (118) est disposée contre au moins une partie des flancs latéraux du trou et/ou de la tranchée (116) formée par la première couche (106) de semi-conducteur.

4. Dispositif optoélectronique (100) selon la revendication 3, dans lequel plusieurs tranchées (116) traversent la première couche (106) de semi-conducteur, la grille (118) étant disposée, dans chacune des tranchées (116), contre les flancs latéraux formés par la première couche (106) de semi-conducteur.

5. Dispositif optoélectronique (100) selon l'une des revendications 3 ou 4, dans lequel au moins une partie de la deuxième électrode (128) traverse au moins la deuxième couche (108) de semi-conducteur depuis une paroi de fond du trou et/ou de la tranchée (116).

6. Dispositif optoélectronique (100) selon l'une des revendications précédentes, comportant en outre une zone active émissive (104) disposée entre les première et deuxième couches (106, 108) de semi-conducteur et dans lequel, lorsqu'un trou et/ou une tranchée (116) traverse la première couche (106) de semi-conducteur, une paroi de fond du trou et/ou de la tranchée (116) est formée par la zone active émissive (104) et est recouverte par la grille (118).

7. Dispositif optoélectronique (100) selon l'une des revendications précédentes, dans lequel une partie de la grille (118) est disposée sur la première couche (106) de semi-conducteur et est en contact avec la deuxième électrode (128).

8. Dispositif optoélectronique (100) selon l'une des revendications précédentes, comportant en outre au moins une couche métallique (112) recouvrant la première couche (106) de semi-conducteur et qui est en contact avec la première électrode (122).

9. Dispositif optoélectronique (100) selon l'une des revendications précédentes, dans lequel la première couche (106) de semi-conducteur et/ou la deuxième couche (108) de semi-conducteur comporte de l'AIGaN.

10. Procédé de réalisation d'un dispositif optoélectronique (100) comportant au moins les étapes de :
- réalisation d'une première couche (106) de semi-conducteur dopé p et d'une deuxième couche (108) de semi-conducteur dopé n superposées et formant ensemble une jonction p-n ;
- réalisation d'une grille (118), comprenant au moins un diélectrique de grille et une couche de matériau électriquement conducteur de la grille, disposée contre au moins un flanc latéral d'au moins une partie de la première couche (106) de semi-conducteur et ne recouvrant pas des flancs latéraux de la deuxième couche (108) ;
- réalisation d'une première électrode (122) reliée électriquement à la première couche (106) de semi-conducteur et formant une anode du dispositif optoélectronique (100) ;
- réalisation d'une deuxième électrode (128) disposée contre au moins un des flancs latéraux d'au moins une partie de la deuxième couche (108) de semi-conducteur, reliée électriquement à ladite partie de la deuxième couche (108) de semi-conducteur et isolée électriquement de la première couche (106) de semi-conducteur, et telle qu'au moins une portion (132) de la deuxième électrode (128) soit disposée contre le matériau électriquement conducteur de la grille (118) afin que la deuxième électrode (128) soit reliée électriquement au matériau électriquement conducteur de la grille (118) et forme à la fois une électrode de grille et une cathode du dispositif optoélectronique (100).

11. Procédé selon la revendication 10, comportant en outre, entre la réalisation des première et deuxième couches (106, 108) de semi-conducteur et la réalisation de la grille (118), la réalisation d'au moins un trou et/ou une tranchée (116) à travers la première couche (106) de semi-conducteur, et dans lequel la grille (118) est réalisée ensuite telle qu'elle soit disposée contre au moins une partie des flancs latéraux du trou et/ou de la tranchée (116) formée par la première couche (106) de semi-conducteur.

12. Procédé selon la revendication 11, dans lequel la réalisation de la deuxième électrode (128) comporte la réalisation d'au moins une ouverture (119) à travers au moins la deuxième couche (108) de semi-conducteur depuis une paroi de fond du trou et/ou de la tranchée (116), puis le remplissage de l'ouverture (119) par au moins un matériau électriquement conducteur.

13. Procédé selon l'une des revendications 10 à 12, dans lequel :
- la réalisation de la jonction p-n comporte en outre la réalisation d'une zone active émissive (104) disposée entre les première et deuxième couches (106, 108) de semi-conducteur,
- lorsqu'un trou et/ou une tranchée (116) est réalisé à travers la première couche (106) de semi-conducteur, une gravure formant le trou et/ou la tranchée (116) est stoppée sur la zone active émissive (104) telle qu'une paroi de fond du trou et/ou de la tranchée (116) soit formée par la zone active émissive (104),
- la grille (118) est réalisée telle qu'elle recouvre la paroi de fond du trou et/ou de la tranchée (116).

14. Procédé selon l'une des revendications 10 à 13, dans lequel la grille (118) est réalisée par la mise en oeuvre d'un dépôt du matériau diélectrique de grille (118) contre ledit au moins un flanc latéral d'au moins une partie de la première couche (106) de semi-conducteur et sur la première couche (106) de semi-conducteur, et d'un dépôt du matériau électriquement conducteur de la grille (118) sur le matériau diélectrique de grille (118), et dans lequel la deuxième électrode (128) est réalisée telle que la portion (132) de la deuxième électrode (128) qui disposée contre le matériau électriquement conducteur de la grille (118) soit disposée sur la première couche (106) de semi-conducteur.

## Patentansprüche

1. Optoelektronische Vorrichtung (100), welche mindestens beinhaltet:
- eine erste p-dotierte Halbleiterschicht (106) und eine zweite n-dotierte Halbleiterschicht (108), die überlagert sind und gemeinsam eine p-n-Verbindungsstelle bilden;
- eine erste Elektrode (122), die elektrisch an die erste Halbleiterschicht (106) angeschlossen ist, und eine Anode der optoelektronischen Vorrichtung (100) bildet;
- ein Gate (118), welches mindestens ein Gate-Dielektrikum und eine elektrisch leitfähige Materialschicht des Gates umfasst, die an mindestens eine Seitenflanke mindestens eines Teils der ersten Halbleiterschicht (106) anliegend angeordnet ist, und Seitenflanken der zweiten Schicht (108) nicht abdeckt;
- eine zweite Elektrode (128), die an mindestens eine der Seitenflanken mindestens eines Teils der zweiten Halbleiterschicht (108) anliegend angeordnet ist, elektrisch an den Teil der zweiten Halbleiterschicht (108) angeschlossen ist, und elektrisch von der ersten Halbleiterschicht (106) isoliert ist;
und wobei mindestens ein Abschnitt (132) der zweiten Elektrode (128) an dem elektrisch leitfähigen Material des Gates (118) anliegend angeordnet ist, sodass die zweite Elektrode (128) elektrisch an das elektrisch leitfähige Material des Gates (118) angeschlossen ist, und gleichzeitig eine Gate-Elektrode und eine Kathode der optoelektronischen Vorrichtung (100) bildet.

2. Optoelektronische Vorrichtung (100) nach Anspruch 1, wobei das Gate-Dielektrikum eine Permittivität größer als etwa 3,2 und eine gleichwertige Oxiddicke aufweist, die zwischen etwa 0,5 nm und 100 nm liegt.

3. Optoelektronische Vorrichtung (100) nach einem der vorstehenden Ansprüche, welche mindestens ein Loch und/oder einen Graben (116) beinhaltet, der die erste Halbleiterschicht (106) durchquert, und wobei das Gate (118) an mindestens einem Teil der Seitenflanken des Loches und/oder Grabens (116), der durch die erste Halbleiterschicht (106) gebildet wird, anliegend angeordnet ist.

4. Optoelektronische Vorrichtung (100) nach Anspruch 3, wobei mehrere Gräben (116) die erste Halbleiterschicht (106) durchqueren, wobei das Gate (118) in jedem der Gräben (116) an den Seitenflanken anliegend angeordnet ist, die von der ersten Halbleiterschicht (106) gebildet werden.

5. Optoelektronische Vorrichtung (100) nach einem der Ansprüche 3 oder 4, wobei mindestens ein Teil der zweiten Elektrode (128) mindestens die zweite Halbleiterschicht (108) aus einer Bodenwand des Loches und/oder des Grabens (116) durchquert.

6. Optoelektronische Vorrichtung (100) nach einem der vorstehenden Ansprüche, welche weiter einen aktiven emittierenden Bereich (104) beinhaltet, welcher zwischen der ersten und zweiten Halbleiterschicht (106, 108) angeordnet ist, und wobei, wenn ein Loch und/oder ein Graben (116) die erste Halbleiterschicht (106) durchquert, eine Bodenwand des Loches und/oder des Grabens (116) durch den aktiven emittierenden Bereich (104) gebildet wird, und von dem Gate (118) abgedeckt wird.

7. Optoelektronische Vorrichtung (100) nach einem der vorstehenden Ansprüche, wobei ein Teil des Gates (118) auf der ersten Halbleiterschicht (106) angeordnet ist, und in Kontakt mit der zweiten Elektrode (128) ist.

8. Optoelektronische Vorrichtung (100) nach einem der vorstehenden Ansprüche, welche weiter mindestens eine Metallschicht (112) beinhaltet, welche die erste Halbleiterschicht (106) abdeckt, und welche in Kontakt mit der ersten Elektrode (122) ist.

9. Optoelektronische Vorrichtung (100) nach einem der vorstehenden Ansprüche, wobei die erste Halbleiterschicht (106) und/oder die zweite Halbleiterschicht (108) AlGaN beinhaltet.

10. Verfahren zum Herstellen einer optoelektronischen Vorrichtung (100), welches mindestens die Schritte beinhaltet zum:
- Herstellen einer ersten p-dotierte Halbleiterschicht (106) und einer zweiten n-dotierte Halbleiterschicht (108), die überlagert sind und gemeinsam eine p-n-Verbindungsstelle bilden;
- Herstellen eines Gates (118), welches mindestens ein Gate-Dielektrikum und eine elektrisch leitfähige Materialschicht des Gates umfasst, die an mindestens eine Seitenflanke mindestens eines Teils der ersten Halbleiterschicht (106) anliegend angeordnet ist, und Seitenflanken der zweiten Schicht (108) nicht abdeckt;
- Herstellen einer ersten Elektrode (122), die elektrisch an die erste Halbleiterschicht (106) angeschlossen ist, und eine Anode der optoelektronischen Vorrichtung (100) bildet;
- Herstellen einer zweiten Elektrode (128), die an mindestens eine der Seitenflanken mindestens eines Teils der zweiten Halbleiterschicht (108) anliegend angeordnet ist, elektrisch an den Teil der zweiten Halbleiterschicht (108) angeschlossen ist, und elektrisch von der ersten Halbleiterschicht (106) isoliert ist, und sodass mindestens ein Abschnitt (132) der zweiten Elektrode (128) an dem elektrisch leitfähigen Material des Gates (118) anliegend angeordnet ist, damit die zweite Elektrode (128) elektrisch an das elektrisch leitfähige Material des Gates (118) angeschlossen ist, und gleichzeitig eine Gate-Elektrode und eine Kathode der optoelektronischen Vorrichtung (100) bildet.

11. Verfahren nach Anspruch 10, welches weiter zwischen dem Herstellen der ersten und zweiten Halbleiterschicht (106, 108) und dem Herstellen des Gates (118) das Herstellen mindestens eines Loches und/oder eines Grabens (116) durch die erste Halbleiterschicht (106) hindurch beinhaltet, und wobei das Gate (118) danach hergestellt wird, sodass es an mindestens einem Teil der Seitenflanken des Loches und/oder Grabens (116), der durch die erste Halbleiterschicht (106) gebildet wird, anliegend angeordnet ist.

12. Verfahren nach Anspruch 11, wobei das Herstellen der zweiten Elektrode (128) das Herstellen mindestens einer Öffnung (119) durch mindestens die zweite Halbleiterschicht (108) hindurch aus einer Bodenwand des Loches und/oder des Grabens (116), und danach das Füllen der Öffnung (119) mit mindestens einem elektrisch leitfähigen Material beinhaltet.

13. Verfahren nach einem der Ansprüche 10 bis 12, wobei:
- das Herstellen der p-n-Verbindungsstelle weiter das Herstellen eines aktiven emittierenden Bereichs (104) beinhaltet, welcher zwischen der ersten und zweiten Halbleiterschicht (106, 108) angeordnet ist,
- wenn ein Loch und/oder ein Graben (116) durch die erste Halbleiterschicht (106) hindurch hergestellt wird, eine Gravur, welche das Loch und/oder den Graben (116) bildet, im aktiven emittierenden Bereich (104) gestoppt wird, sodass eine Bodenwand des Loches und/oder des Grabens (116) durch den aktiven emittierenden Bereich (104) gebildet wird,
- das Gate (118) hergestellt wird, sodass es die Bodenwand des Loches und/oder des Grabens (116) abdeckt.

14. Verfahren nach einem der Ansprüche 10 bis 13, wobei das Gate (118) durch Ausführen eines Abscheidens des dielektrischen Materials des Gates (118) an der mindestens einen Seitenflanke mindestens eines Teils der ersten Halbleiterschicht (106) und auf der ersten Halbleiterschicht (106), und eines Abscheidens des elektrisch leitfähigen Materials des Gates (118) auf dem dielektrischen Material des Gates (118) hergestellt wird, und wobei die zweite Elektrode (128) hergestellt wird, sodass der Abschnitt (132) der zweiten Elektrode (128), die an dem elektrisch leitfähigen Material des Gates (118) anliegend angeordnet ist, auf der ersten Halbleiterschicht (106) angeordnet ist.

## Claims

1. Optoelectronic device (100) including at least:
- a first p-doped semiconductor layer (106) and a second n-doped semiconductor layer (108) placed one on top of the other and together forming a p-n junction;
- a first electrode (122) electrically connected to the first semiconductor layer (106) and forming an anode of the optoelectronic device (100);
- a gate (118), comprising at least one gate dielectric and a layer of electrically conductive material of the gate, arranged against at least one lateral side of at least a portion of the first semiconductor layer (106);
- a second electrode (128) arranged against at least one lateral side of at least a portion of the second semiconductor layer (108), electrically connected to said portion of the second semiconductor layer (108) and electrically insulated from the first semiconductor layer (106);
and wherein at least one portion (132) of the second electrode (128) is arranged against the electrically conducting material of the gate (118) in such a way that the second electrode (128) is electrically connected to the electrically conducting material of the gate (118) and forms both a gate electrode and a cathode of the optoelectronic device (100).

2. Optoelectronic device (100) according to claim 1, wherein the gate dielectric has a permittivity greater than about 3.2 and an equivalent oxide thickness of between about 0.5 nm and 100 nm.

3. Optoelectronic device (100) according to claim 1 or 2, including at least one hole and/or trench (116) extending through the first semiconductor layer (106), and wherein the gate (118) is arranged against at least a portion of the lateral sides of the hole and/or trench (116) formed by the first semiconductor layer (106).

4. Optoelectronic device (100) according to claim 3, wherein a plurality of trenches (116) extend through the first semiconductor layer (106), with the gate (118) being placed in each trench (116) against the lateral sides formed by the first semiconductor layer (106).

5. Optoelectronic device (100) according to claim 3, wherein at least a portion of the second electrode (128) extends through at least the second semiconductor layer (108) from a bottom wall of the hole and/or trench (116).

6. Optoelectronic device (100) according to claim 1 or 2, furthermore including an active emission area (104) placed between the first and second semiconductor layers (106, 108), and wherein, when a hole and/or trench (116) extends through the first semiconductor layer (106), a bottom wall of the hole and/or of the trench (116) is formed by the active emission area (104) and is covered by the gate (118).

7. Optoelectronic device (100) according to claim 1 or 2, wherein a portion of the gate (118) is placed on the first semiconductor layer (106) and is in contact with the second electrode (128).

8. Optoelectronic device (100) according to claim 1 or 2, furthermore including at least one metal layer (112) covering the first semiconductor layer (106) and in contact with the first electrode (122).

9. Optoelectronic device (100) according to claim 1 or 2, wherein the first semiconductor layer (106) and/or the second semiconductor layer (108) includes AlGaN.

10. Method for making an optoelectronic device (100) including at least the steps of:
- making a first p-doped semiconductor layer (106) and a second n-doped semiconductor layer (108) placed one on top of the other and together forming a p-n junction;
- making a gate (118), comprising at least one gate dielectric and a layer of electrically conductive material of the gate, arranged against at least one lateral side of at least a portion of the first semiconductor layer (106);
- making a first electrode (122) electrically connected to the first semiconductor layer (106) and forming an anode of the optoelectronic device (100);
- making a second electrode (128) arranged against at least one lateral side of at least one portion of the second semiconductor layer (108), electrically connected to said portion of the second semiconductor layer (108) and electrically insulated from the first semiconductor layer (106), such that at least one portion (132) of the second electrode (128) is arranged against the electrically conductive material of the gate (118) so that the second electrode (128) is electrically connected to the electrically conductive material of the gate (118) and forms both a gate electrode and a cathode of the optoelectronic device (100).

11. Method according to claim 10 further including, between the making of the first and second semiconductor layers (106, 108) and the making of the gate (118), the making of at least one hole and/or trench (116) through the first semiconductor layer (106), and wherein the gate (118) is subsequently made in such a way that the gate (118) is arranged against at least one portion of the lateral sides of the hole and/or the trench (116) formed by the first semiconductor layer (106).

12. Method according to claim 11 wherein the making of the second electrode (128) includes the making of at least one opening (119) through at least the second semiconductor layer (108) from a bottom wall of the hole and/or trench (116), and then filling of the opening (119) with at least one electrically conductive material.

13. Method according claim 10 or 11, wherein:
- the making of the p-n junction additionally includes the making of an active emission area (104) placed between the first and second semiconductor layers (106, 108),
- when a hole and/or trench (116) is made through the first semiconductor layer (106), an etching forming the hole and/or trench (116) is stopped at the active emission area (104) in such a way that a bottom wall of the hole and/or trench (116) is formed by the active emission area (104),
- the gate (118) is made so as to cover the bottom wall of the hole and/or trench (116).

14. Method according to claim 10 or 11 wherein the gate (118) is made by means of depositing the gate dielectric material (118) against said at least one lateral side of at least one portion of the first semiconductor layer (106) and on the first semiconductor layer (106), and depositing the electrically conductive material of the gate (118) on the gate dielectric material (118), and wherein the second electrode (128) is made such that the portion (132) of the second electrode (128) arranged against the electrically conductive material of the gate (118) is arranged on the first semiconductor layer (106).
